# EUROPÄISCHE PATENTSCHRIFT

(11) **EP 2 737 004 B1**
(45) Veröffentlichungstag und Bekanntmachung des Hinweises auf die Patenterteilung: **04.05.2016**
(21) Anmeldenummer: 12743106.2
(22) Anmeldetag: 18.07.2012
(51) Int. Cl.: C09K 11/06, H05B 33/14, H01L 51/00, H01L 51/50

(54) **KOMPLEXVERBINDUNGEN MIT ANIONISCHEN LIGANDEN MIT ZWEI P-DONOREN UND IHRE VERWENDUNG IM OPTO-ELEKTRONISCHEN BEREICH**
COMPLEX COMPOUNDS COMPRISING ANIONIC LIGANDS THAT HAVE TWO P-DONORS, AND USE THEREOF IN THE OPTOELECTRONIC FIELD
COMPOSÉS DE TYPE COMPLEXES DOTÉS DE LIGANDS ANIONIQUES POURVUS DE DEUX DONNEURS P, ET LEUR UTILISATION DANS LE DOMAINE DE L'ÉLECTRO-OPTIQUE

(30) Priorität: 26.07.2011 DE 102011079847
(43) Veröffentlichungstag der Anmeldung: 04.06.2014
(73) Patentinhaber: Merck Patent GmbH, 64293 Darmstadt (DE)
(72) Erfinder: WESEMANN, Lars, 72072 Tübingen (DE); SCHUBERT, Hartmut, 72411 Bodelshausen (DE); MAYER, Hermann August, 72076 Tübingen (DE); YERSIN, Hartmut, 93161 Sinzing (DE); RAUSCH, Andreas, 84533 Haiming (DE)
(86) Internationale Anmeldenummer: PCT/EP2012/064126
(87) Internationale Veröffentlichungsnummer: WO 2013/014049

(56) Entgegenhaltungen:
- WO-A1-2005/118606
- US-A1- 2002 048 689
- YI-MING CHENG ET AL: "Rational design of chelating phosphine functionalized Os(II) emitters and fabrication of orange polymer light-emiting diodes using solution process", ADVANCED FUNCTIONAL MATERIALS, WILEY - V C H VERLAG GMBH & CO. KGAA, DE, Bd. 18, Nr. 2, 24. Januar 2008 (2008-01-24), Seiten 183-194, XP001510283, ISSN: 1616-301X, DOI: 10.1002/ADFM.200700831
- STEVEN&EMSP14;C.&EMSP14;F. KUI ET AL: "Platinum(II) Complexes with [pi]-Conjugated, Naphthyl-Substituted, Cyclometalated Ligands (RC^N^N): Structures and Photo- and Electroluminescence", CHEMISTRY - A EUROPEAN JOURNAL, Bd. 13, Nr. 2, 30. November 2006 (2006-11-30), Seiten 417-435, XP55039956, ISSN: 0947-6539, DOI: 10.1002/chem.200600686
- OMAR MOUDAM ET AL: "Electrophosphorescent homo- and heteroleptic copper(i) complexes prepared from various bis-phosphine ligands", CHEMICAL COMMUNICATIONS, Nr. 29, 1. Januar 2007 (2007-01-01), Seite 3077, XP55039955, ISSN: 1359-7345, DOI: 10.1039/b707398d

## Beschreibung

Die vorliegende Erfindung betrifft elektronische Vorrichtungen wie organische Elektrolumineszenzvorrichtungen (OLEDs), lichtemittierende elektrochemische Zellen (LEECs), organische Solarzellen (OSCs), organische Feldeffekttransistoren und organische Laser, die Organo-Übergangsmetall-Komplexverbindungen als Lichtemitter und/oder Lichtabsorber aufweisen. Beschrieben werden einige besonders geeignete Komplexverbindungen und ihre Verwendung im opto-elektronischen Bereich.

Organo-Übergangsmetall-Komplexverbindungen sind wichtige Bausteine für opto-elektronische Vorrichtungen wie organische Solarzellen oder organische Elektrolumineszenzvorrichtungen. Dies gilt insbesondere für Verbindungen, die als Triplett-Emitter fungieren können. Bei einer Triplett-Emission, auch als Phosphoreszenz bezeichnet, können hohe innere Quantenausbeuten von bis zu 100 % erreicht werden, sofern der mit angeregte und energetisch über dem Triplett-Zustand liegende Singulett-Zustand vollständig in den Triplett-Zustand relaxieren kann und strahlungslose Konkurrenzprozesse bedeutungslos bleiben. Viele für opto-elektronische Anwendungen grundsätzlich geeignete Triplett-Emitter weisen allerdings den Nachteil einer hohen Emissionslebensdauer auf, die z.B. in mit derartigen Emittern versehenen OLED-Vorrichtungen zu einem Effizienz-Abfall führen kann.

Von Yersin et al. wurden in der WO 2010/006681 A1 Organo-Übergangsmetall-Verbindungen vorgeschlagen, die einen sehr kleinen energetischen Abstand ΔE zwischen dem untersten Triplett-Zustand und dem darüber liegenden Singulett-Zustand aufweisen, und bei denen deshalb schon bei Raumtemperatur eine effiziente Rückbesetzung aus dem effizient besetzten T₁-Zustand in den S₁-Zustand erfolgen kann. Durch diese Rückbesetzung wird ein schneller Emissionskanal aus dem kurzlebigen S₁-Zustand geöffnet, wodurch es gelingt, die Gesamtemissionslebensdauer deutlich zu reduzieren. Als besonders geeignet hierfür wurden Komplexe mit Metallzentren mit einer d⁸-Elektronenkonfiguration beschrieben, also insbesondere auf Basis der sehr teuren Metalle Rhodium, Iridium, Palladium, Platin und Gold.

Der vorliegenden Erfindung lag die Aufgabe zugrunde, Organo-Übergangsmetall-Komplexverbindungen auf Basis von gut verfügbaren und möglichst kostengünstigen Übergangsmetallen bereitzustellen, die in ihren physikalischen Eigenschaften wie Farbreinheit, Emissionsabklingzeit und Quanteneffizienz den aus der WO 2010/006681 bekannten Organo-Übergangsmetall-Komplexverbindungen idealerweise mindestens ebenbürtig sind.

Aus WO 2005/118606 sind OLEDs bekannt, die Metallkomplexe wie beispielsweise den positiv geladene Komplex B-138 enthalten, welches ein Iridiumkomplex mit zwei Phenylpyridinliganden und einem neutralen Diphosphinomethanliganden ist. Es sind keine Metallkomplexe mit anionischen Diphosphinliganden offenbart.

Aus Advanced Functional Materials 2008, 18, 183-194 sind die Metallkomplexe 3a und 3b, sowie deren Verwendung in OLEDs bekannt, wobei es sich um Osmiumkomplexe mit einem neutralen Diphosphinomethanliganden handelt. Es sind keine Metallkomplexe mit anionischen Diphosphinliganden offenbart.

Aus Chem. Eur. J. 2007, 13, 417-435 sind die Metallkomplexe 2a bis 2g, 5b und 5d, sowie deren Verwendung in OLEDs bekannt, wobei es sich um zweikernige Platinkomplexe mit einem überbrückenden neutralen Diphosphinomethanliganden handelt. Es sind keine Metallkomplexe mit anionischen Diphosphinliganden offenbart.

Gegenstand der vorliegenden Erfindung ist die elektronische Vorrichtung mit den Merkmalen des Anspruchs 1. Ebenfalls Gegenstand der vorliegenden Erfindung sind die Verfahren mit den Merkmalen der Ansprüche 12 bis 14. Bevorzugte Ausführungsformen der erfindungsgemäßen Vorrichtung sind in den abhängigen Ansprüchen 2 bis 11 angegeben. Der Wortlaut sämtlicher Ansprüche wird hiermit durch Bezugnahme zum Inhalt dieser Beschreibung gemacht.

Eine erfindungsgemäße elektronische Vorrichtung zeichnet sich dadurch aus, dass sie eine Metallkomplexverbindung mit mindestens einem anionischen Liganden mit zwei P-Donoren (P = Phosphor) mit der Formel I 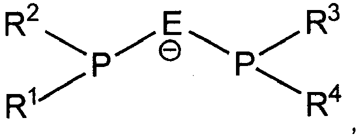 aufweist, in der
- R¹ bis R⁴ unabhängig voneinander ein Atom oder Rest aus der Gruppe umfassend Wasserstoff, ein Halogen, R-, RO-, RS-, RCO-, RCOO-, RNH-, R₂N-, RCONR- und -Si(R)_{X}(OR)_{3-X} mit R = ein C₁-C₄₀-Kohlenwasserstoff und X = 1, 2 oder 3 sind und
- E ein Kohlenstoff ist, an das gegebenenfalls ein Atom oder Rest aus der Gruppe mit Wasserstoff, Halogen, -CN, R-, RO-, RS-, RCO-, RCOO-, RNH-, R₂N-, RCONR- und -Si(R)_{X}(OR)_{3-X} mit R = dem C₁-C₄₀-Kohlenwasserstoff und X = 1, 2 oder 3 gebunden ist, oder
- E ein Bor ist, an das gegebenenfalls zwei Reste aus der Gruppe mit Halogen, R-, RO-, RS-, RCO-, RCOO-, RNH-, R₂N-, RCONR- und - Si(R)_{X}(OR)_{3-X} mit R = dem C₁-C₄₀-Kohlenwasserstoff und X = 1, 2 oder 3 gebunden sind.

Der Ligand weist also bevorzugt eine negative Ladung auf, die am E lokalisiert oder auch delokalisiert sein kann. Bei E handelt es sich somit in bevorzugten Ausführungsformen um ein carbanionisches Fragment mit einem dreibindigen Kohlenstoff oder um ein Alkylborat-Fragment mit einem vierbindigen Bor.

In bevorzugten Ausführungsformen können E und eines oder gar beide P Teil eines Elektronensystems sein, über das die negative Ladung delokalisiert ist. Die Delokalisierung der Elektronen kann sich gegebenenfalls auch auf die angebundenen Reste R¹ bis R⁴ sowie auf an E gebundene Reste erstrecken, wenn diese konjugierte Doppelbindungen enthalten oder aromatischer Natur sind.

Bei dem C₁- bis C₄₀-Kohlenwasserstoff R handelt es sich bevorzugt um einen Alkyl-, Cycloalkyl-, Alkenyl-, Cycloalkenyl-, Alkinyl-, Cycloalkinyl-, Alkylcycloalkyl, Heteroalkyl-, Heterocycloalkyl-, Heteroalkylcycloalkyl-, Aryl-, Heteroaryl-, Aralkyl- oder Heteroaralkyl-Rest. Jeder dieser Reste kann in bevorzugten Ausführungsformen eine odere mehrere Halogen-, Hydroxy-, Thiol-, Carbonyl-, Keto-, Carboxyl-, Cyano-, Sulfon-, Nitro-, Amino- und/oder Imino-Funktionen aufweisen.

Der Ausdruck Alkyl-Rest bezieht sich insbesondere auf eine gesättigte, geradkettige oder verzweigte Kohlenwasserstoffgruppe, die 1 bis 20 Kohlenstoffatome, vorzugsweise 1 bis 12 Kohlenstoffatome, besonders bevorzugt 1 bis 6 Kohlenstoffatome, aufweist. Beispiele hierfür sind die Methyl-, Ethyl-, Propyl-, Isopropyl-, Isobutyl-, t-Butyl, n-Hexyl-, 2,2-Dimethylbutyl- oder n-Octyl-Gruppe.

Die Ausdrücke Alkenyl- und Alkinyl-Rest beziehen sich insbesondere auf zumindest teilweise ungesättigte, geradkettige oder verzweigte Kohlenwasserstoffgruppen, die 2 bis 20 Kohlenstoffatome, vorzugsweise 2 bis 12 Kohlenstoffatome, besonders bevorzugt 2 bis 6 Kohlenstoffatome, aufweisen. Beispiele hierfür sind die Ethenyl-, Allyl-, Acetylenyl-, Propargyl-, Isoprenyl-oder Hex-2-enyl-Gruppe.

Die Ausdrücke Cycloalkyl-, Cycloalkenyl- und Cycloalkinyl-Rest beziehen sich insbesondere auf gesättigte oder teilweise ungesättigte cyclische Gruppen, die einen oder mehrere Ringe aufweisen, die insbesondere 3 bis 14 Ring-Kohlenstoffatome, besonders bevorzugt 3 bis 10 Ring-Kohlenstoffatome, aufweisen. Beispiele hierfür sind die Cyclopropyl-, Cyclohexyl-, Tetralin- oder Cyclohex-2-enyl-Gruppe.

Der Ausdruck Heteroalkyl-Rest bezieht sich insbesondere auf eine Alkyl-, eine Alkenyl- oder eine Alkinyl-Gruppe, in der ein oder mehrere (bevorzugt 1, 2 oder 3) Kohlenstoffatome bzw. CH- oder CH₂-Gruppen durch ein Sauerstoff-, Stickstoff-, Phosphor- und/oder Schwefelatom ersetzt sind. Beispiele hierfür sind Alkyloxy-Gruppen wie Methoxy- oder Ethoxy- oder tertiäre Aminstrukturen.

Der Ausdruck Heterocycloalkyl-Rest bezieht sich insbesondere auf eine Cycloalkyl-, Cycloalkenyl- oder Cycloalkinyl-Gruppe, in der ein oder mehrere (bevorzugt 1, 2 oder 3) Ring-Kohlenstoffatome bzw. Ring-CH- oder CH₂-Gruppen durch ein Sauerstoff-, Stickstoff-, Phosphor- und/oder Schwefelatom ersetzt sind, und kann beispielsweise für die Piperidin- oder N-Phenylpiperazin-Gruppe stehen.

Der Ausdruck Aryl-Rest bezieht sich insbesondere auf eine aromatische Gruppe, die einen oder mehrere Ringe hat, die insbesondere 5 oder 6 bis 14 Ring-Kohlenstoffatome, besonders bevorzugt 5 oder 6 bis 10 Ring-Kohlenstoffatome, enthalten. Beispiele hierfür sind eine Phenyl-, Naphthyl-oder 4-Hydroxyphenyl-Gruppe.

Der Ausdruck Heteroaryl-Rest bezieht sich insbesondere auf eine ArylGruppe, in der ein oder mehrere (bevorzugt 1, 2 oder 3) Ring-Kohlenstoffatome bzw. Ring-CH- oder -CH₂-Gruppen durch ein Sauerstoff-, Stickstoff-, Phosphor- und/oder Schwefelatom ersetzt sind. Beispiele hierfür sind die 4-Pyridyl-, 2-Imidazolyl- oder die 3-Pyrazolyl-Gruppe.

Die Ausdrücke Aralkyl- bzw. Heteroaralkyl-Rest beziehen sich insbesondere auf Gruppen, die entsprechend den obigen Definitionen sowohl Aryl- und/oder Heteroaryl-Gruppen als auch Alkyl-, Alkenyl-, Alkinyl- oder Heteroalkyl-Gruppen aufweisen. Beispiele hierfür sind Arylalkyl-, Arylalkenyl-, Arylalkinyl-, Arylheteroalkyl-, Arylheteroalkenyl-, Arylheteroalkinyl-, Heteroarylheteroalkyl-, Heteroarylheteroalkenyl-, Heteroarylheteroalkinyl-, Arylcycloalkyl-, Heteroarylcycloalkyl-, Arylheterocycloalkyl, Heteroarylheterocycloalkyl-, Heteroarylcycloalkenyl-, Arylcycloalkenyl, Arylcycloalkinyl-, Heteroarylcycloalkinyl-, Arylheteroalkenyl-, Heteroarylheteroalkenyl-, Arylheteroalkinyl-, Heteroarylheteroalkinyl-, Heteroarylalkyl-, Heteroalkenyl- und Heteroarylalkinyl-Gruppen.

Die Ausdrücke Alkylcycloalkyl- bzw. Heteroalkylcycloalkyl-Rest beziehen sich auf Gruppen, die entsprechend den obigen Definitionen sowohl Cycloalkyl- bzw. Heterocycloalkyl- als auch Alkyl-, Alkenyl-, Alkinyl- und/oder Heteroalkylgruppen enthalten. Beispiele derartiger Gruppen sind Alkylcycloalkyl-, Alkenylcycloalkyl, Alkinylcycloalkyl, Alkylheterocycloalkyl, Alkenylheterocycloalkyl-, Alkinylheterocycloalkyl-, Heteroalkylcycloalkyl-, Heteroalkenylcycloalkyl-, Heteroalkylheterocycloalkyl-, Heteroalkenylheterocycloalkyl-, Heteroalkinylcycloalkyl-, und Heteroalkinylheterocycloalkyl-Gruppen.

Unter einem Silylrest wird im Rahmen der vorliegenden Erfindung insbesondere eine Gruppe der oben beschriebenen allgemeinen Formel Si(R)_{X}(OR)_{3-X} mit X = 1, 2 oder 3 verstanden, wobei R bevorzugt ein Alkyl-, Cycloalkyl-, Alkenyl-, Cycloalkenyl-, Alkinyl-, Cycloalkinyl-, Alkylcycloalkyl-, Heteroalkyl-, Heterocycloalkyl-, Heteroalkylcycloalkyl-, Aryl-, Heteroaryl-, Aralkyl- oder Heteroaralkyl-Rest ist, wie er oben definiert wurde. Als Beispiele für die Silylreste seien -Si(OMe)₃, -Si(Me)₃, -SiMe₂₋(OMe), -Si(OPh)₃, -Si(Ph)₃, -SiMe₂(OPh), -Si(OEt)₃, -Si(Et)₃, -SiMe-(OEt)₂, -SiMe₂(OEt), -Si(OPr)₃, -Si(Pr)₃, -SiMe₂(OPr), -SiEt(OMe)₂,-SiEt₂(OMe), -SiPh(OMe)₂, -SiPh₂(OMe), -SiMe₂(OC(O)Me), -SiMe(O-N=CMe₂)₂ oder -SiMe₂(O-N=CMe₂) aufgeführt, wobei die Abkürzungen Me für Methyl-, Ph für Phenyl-, Et für Ethyl- und Pr für iso- bzw. n-Propyl- stehen.

In besonders bevorzugten Ausführungsformen ist mindestens eines der beiden P ein Ringatom eines Ringsystems aromatischer oder nicht aromatischer Natur. In diesem Fall sind R¹ und R² sowie R³ und R⁴ Fragmente des entsprechenden Ringsystems. R¹ und R² und/oder R³ und R⁴ bilden dann gemeinsam mit dem entsprechenden P einen Heterocycloalkyl-, Heteroaryl-, Heteroaralkyl- oder Heteroalkylcycloalkyl-Rest oder zumindest einen Teil eines solchen aus, wie er oben definiert ist. Beispiele hierfür sind 5- und 6-gliedrige Ringsysteme, wie sie im Folgenden dargestellt sind, wobei in den Formeln R', R", R'" unabhängig voneinander bevorzugt Wasserstoff, Halogen oder der oben beschriebene C₁- bis C₄₀-Kohlenwasserstoff R sind:

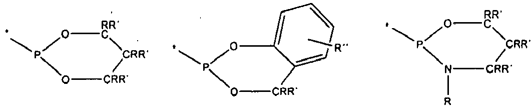

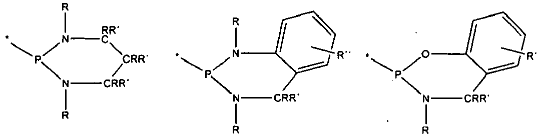

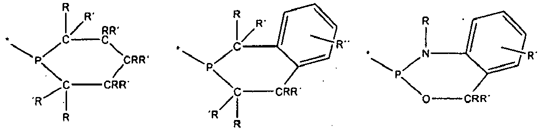

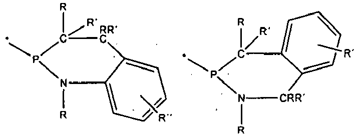

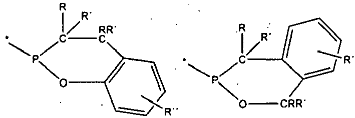

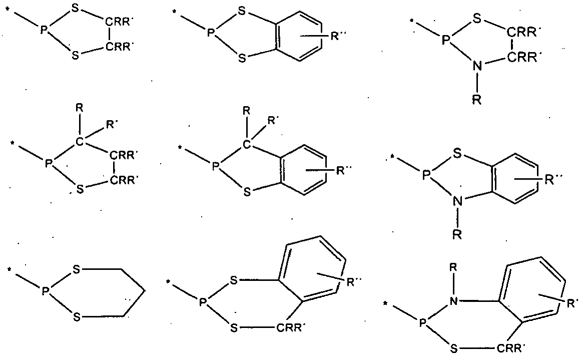

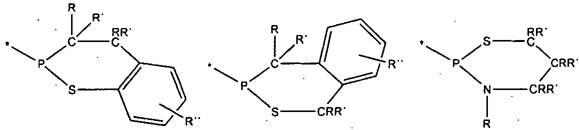

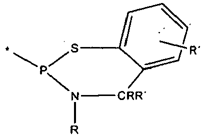

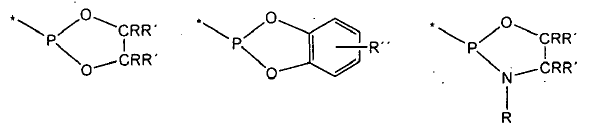

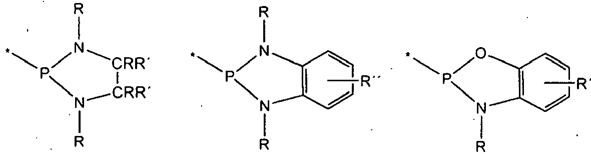

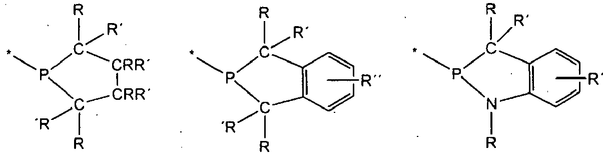

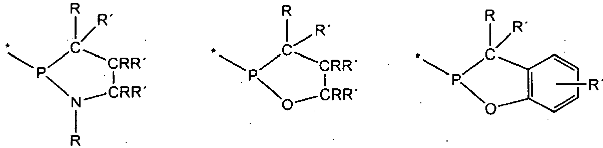

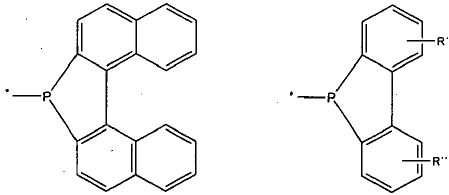

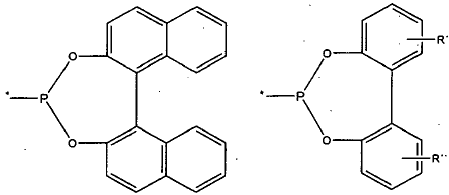

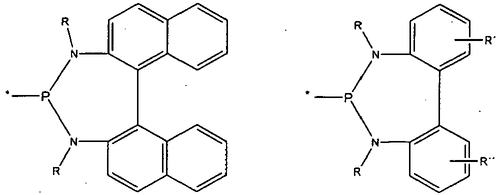

Zu beachten ist hierbei, dass die dargestellten Ringsysteme über die mit "*" gekennzeichnete Bindung an E gebunden sind

Grundsätzlich kann es sich bei der Metallkomplexverbindung um einen einkernigen oder mehrkernigen Metallkomplex handeln. Bevorzugt weist der Metallkomplex zwischen 2 und 6 Metallzentren auf.

Grundsätzlich kann es sich bei der Metallkomplexverbindung um einen Kupfer-, Silber-, Gold-, Palladium-, Platin-, Rhodium-, Iridium-, Rhenium-, Osmium-, Molybdän-, Wolfram- oder Zink-Komplex oder um einen Komplex mit zwei oder mehr dieser Metalle handeln. Die Metalle liegen in der Regel als Kationen vor und sind 1- bis 6-fach positiv geladen.

In besonders bevorzugten Ausführungsformen weist die Metallkomplexverbindung Kupfer- oder Silberionen als Zentrum oder Zentren auf, bevorzugt in ionischer Form.

Besonders bevorzugt umfasst die erfindungsgemäße elektronische Vorrichtung Metallkomplexverbindungen der Formel II 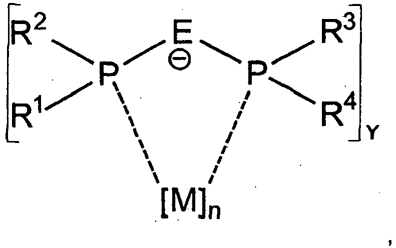 in der
- R¹ bis R⁴ und E definiert sind wie in.Formel I und
- [M]ₙ ein Komplexfragment darstellt mit M = Cu, Ag, Au, Pd, Pt, Rh, Ir, Re, Os, Mo, W oder Zn und
- n = 1 oder eine größere ganze Zahl ist, insbesondere eine ganze Zahl von 1 bis 6 und
- y gleich 1, 2 oder 3 ist.

Die Variable n ist besonders bevorzugt 1, es handelt sich also bei Metallkomplexverbindungen der Formel II bevorzugt um eine einkernige Komplexverbindung.

Wenn n > 1 ist, dann umfasst M bevorzugt Cu oder Ag sowie mindestens ein weiteres Metall aus der Gruppe mit Cu, Ag, Au, Pd, Pt, Rh, Ir, Re, Os, Mo, W und Zn.

Potentielle Koordinationsmöglichkeiten zwischen dem Metallzentrum [M]ₙ und den Donoren P sind als gestrichelte Linien dargestellt.

Freie Valenzen von [M]ₙ sind bei Bedarf mit überbrückenden und/oder nicht überbrückenden Liganden abgesättigt.

Unter nicht überbrückenden Liganden sollen vorliegend Liganden verstanden werden, die nicht gleichzeitig an zwei oder mehr Metallzentren binden. Wenngleich solche Liganden nicht strukturbildend sind, können sie einen großen Einfluss auf die Abstände zwischen den Metallzentren eines mehrkernigen Komplexes nehmen, indem sie die Elektronendichten an den Metallzentren erhöhen oder erniedrigen. Wichtig sind die Liganden für die Absättigung der Koordinationssphäre des Metalls oder für den Ladungsausgleich oder für beides. Daher können diese Liganden neutral oder anionisch sein. Weiterhin können die Liganden monodentat oder bidentat sein.

Geeignete neutrale, monodentate Liganden sind vorzugsweise ausgewählt aus der Gruppe mit Kohlenmonoxid, Stickstoffmonoxid, Nitrilen (RCN), Isonitrilen (RNC) wie z.B. t-Butylisonitril, Cyclohexylisonitril, A-damantylisonitril, Phenylisonitril, Mesitylisonitril und 2,6-Dimethylphenylisonitril, Ethern wie z. B. Dimethylether und Diethylether, Seleniden, Aminen wie z. B. Trimethylamin, Triethylamin und Morpholin, Iminen (RN=CR'), Phosphinen wie z. B Triphenylphosphin, Phosphiten wie z.B. Trimethylphosphit, Arsinen, wie z.B. Trifluorarsin, Trimethylarsin und Triphenylarsin, Stibinen wie z.B. Trifluorstibin oder Triphenylstibin und stickstoffhaltigen Heterocyclen wie z.B. Pyridin, Pyridazin, Pyrazin, Pyrimidin und Triazin.

Geeignete anionische, monodentate Liganden sind vorzugsweise ausgewählt aus der Gruppe mit Hydrid, Deuterid, den Halogeniden F, Cl, Br und I, Azid, Alkylacetyliden, Aryl- bzw. Heteroarylacetyliden, Alkyl, Aryl und Heteroaryl, wie sie oben definiert wurden, Hydroxid, Cyanid, Cyanat, Isocyanat, Thiocyanat, Isothiocyanat, aliphatischen oder aromatischen Alkoholaten, wie z.B. Methanolat, Ethanolat, Propanolat und Phenolat, aliphatischen oder aromatischen Thioalkoholaten wie z.B. Methanthiolat, Ethanthiolat, Propanthiolat und Thiophenolat, Amiden, wie z.B. Dimethylamid, Diethylamid und Morpholid, Carboxylaten, wie z.B. Acetat, Trifluoracetat, Propionat und Benzoat, anionischen, stickstoffhaltigen Heterocyclen wie z.B. Pyrrolid, Imidazolid, Pyrazolid, aliphatischen und aromatischen Phosphiden oder aliphatischen oder aromatischen Seleniden.

Geeignete di- bzw. trianionische Liganden sind beispielsweise O²⁻, S²⁻ oder N³⁻.

Als Ligand geeignete neutrale oder mono- oder dianionische bidentate Liganden sind vorzugsweise ausgewählt aus der Gruppe mit Diaminen wie z.B. Ethylendiamin, N,N,N',N'-Tetramethylethylendiamin, Propylendiamin, N,N,N',N'-Tetramethylpropylendiamin, cis- oder trans-Diaminocyclohexan, cis- oder trans-N,N,N',N'-Tetramethyldiaminocyclohexan, Iminen wie z.B. 2-[1-(Phenylimino)ethyl]pyridin, 2-[1-(2-Methylphenylimino)-ethyl]pyridin oder 2-[1-(Ethylimino)ethyl]pyridin, Diiminen wie z.B. 1,2-Bis(methylimino)ethan, 1,2-Bis(ethylimino)ethan, 1,2-Bis(isopropylimino)ethan, 2,3-Bis(methyl-imino)-butan, 2,3-Bis(isopropyl-imino)butan oder 1,2-Bis(2-methylphenylimino)ethan, Heterocyclen enthaltend zwei Stickstoffatome wie z.B. 2,2-bipyridin oder o-Phenanthrolin, Diphosphinen wie z.B. Bis(diphenylphosphino)methan, Bis(diphenylphosphino)ethan, Bis(dimethylphosphino)methan, Bis(dimethylphosphino)ethan, Bis-(diethylphosphino)methan oder Bis(diethylphosphino)ethan, 1,3-Diketonaten abgeleitet von 1,3-Diketonen wie z.B. Acetylaceton, Benzoylaceton, 1,5-Diphenylacetylaceton, Dibenzoylmethan und Bis(1,1,1-trifluoracetyl)methan, 3-Ketonaten abgeleitet von 3-Ketoestern wie z.B. Acetessigsäureethylester, Carboxylate abgeleitet von Aminocarbonsäuren wie z.B. Pyridin-2-carbonsäure, Chinolin-2-carbonsäure, Glycin, N,N-Dimethylglycin, Alanin, N,N-Dimethylaminoalanin, Salicyliminaten abgeleitet von Salicyliminen wie z.B. Methylsalicylimin, Ethylsalicylimin, Phenylsalicylimin, Dialkoholaten abgeleitet von Dialkoholen wie z.B. Ethylenglykol, 1,3-Propylenglykol und Dithiolaten abgeleitet von Dithiolen wie z.B. 1,2-Ethylendithiol und 1,3-Propylendithiol.

Eingesetzt können weiterhin auch bidentate monoanionische Liganden, welche mit dem Metall einen cyclometallierten Fünfring oder Sechsring mit mindestens einer Metall-Kohlenstoff-Bindung aufweisen, insbesondere einen cyclometallierten Fünfring. Dies sind insbesondere Liganden, wie sie allgemein auf dem Gebiet der phosphoreszierenden Metallkomplexe für organische Elektrolumineszenzvorrichtungen verwendet werden, also Liganden vom Typ Phenylpyridin, Naphthylpyridin, Phenylchinolin, Phenylisochinolin, etc., welche jeweils substituiert oder unsubstituiert sein können. Dem Fachmann auf dem Gebiet der phosphoreszierenden Elektrolumineszenzvorrichtungen sind eine Vielzahl derartiger Liganden bekannt, und er kann ohne erfinderisches Zutun weitere derartige Liganden als Ligand auswählen.

Unter überbrückenden Liganden sollen vorliegend Liganden verstanden werden, die gleichzeitig an zwei oder mehr Metallzentren binden und damit strukturbildend sind. Diese finden somit insbesondere Anwendung, wenn der erfindungsgemäß verwendete Komplex ein mehrkerniger ist. Geeignete überbrückende Liganden weisen in der Regel mindestens zwei Donorgruppen sowie ein die Donorgruppen verbindendes Brückenfragment auf. Bei der Donorgruppe handelt es sich um ein Atom oder eine Atomgruppe, die an das Metallatom bindet. Beide Donorgruppen können gleich oder verschieden sein, es können also auch asymmetrische Liganden verwendet werden

Auch überbrückende Liganden können entweder neutral oder anionisch sein. In letzterem Fall tragen entweder die Donorgruppen eine negative Ladung oder das Brückenfragment.

Neutrale, überbrückende Liganden weisen als Donorgruppen insbesondere Gruppen aus der Reihe mit R₂N-, R₂P-, R₂As-, R₂N-, CN-, NC-, RO-, RS-, RSe- und RN= auf. ("-" oder "=" bezeichnet den Bindungsmodus, mit dem die Donorgruppe an die Brücke gebunden ist, R bevorzugt einen C₁- bis C₄₀-Kohlenwasserstoff, wie er oben definiert wurde). Als Brückenfragment kommt ebenfalls ein Kohlenwasserstoff in Frage, wie er bereits beschrieben wurde, bevorzugt mit maximal 6 C-Atomen.

Bei anionischen, überbrückenden Liganden sind eine oder beide Donorgruppen negativ geladen, oder das Brückenfragment trägt die Ladung. Häufig verwendete anionische Donorgruppen sind: O-, NR- oder C≡C-.Beispiele für anionische, überbrückende Liganden sind beispielsweise

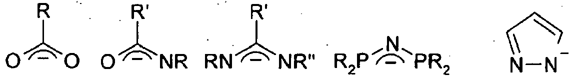

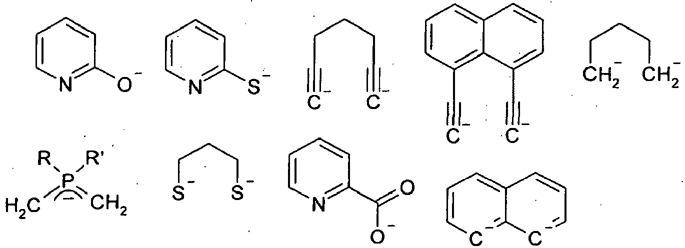

In diesen Formeln stehen R und R' bevorzugt für den oben definierten C₁-C₄₀ Kohlenwasserstoff.

Beispielhaft für einen besonders bevorzugten mehrkernigen Komplex, in dem zwei Metallzentren M über verbrückende Liganden verbunden sind, ist der Metallkomplex der Formel III zu nennen:

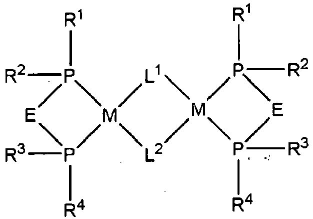

In dieser Formel sind R¹ bis R⁴, M und E definiert sind wie in Formel II. Bei den Liganden L¹ und L² handelt es sich um überbrückende Liganden.

Besonders bevorzugt werden als Metallkomplexe organische Übergangsmetallverbindungen gewählt, die einen ΔE-Abstand zwischen dem untersten Triplett-Zustand und dem darüberliegenden Singulett-Zustand zwischen 50 cm⁻¹ und 3.000 cm⁻¹ aufweisen, also diesbezüglich die gleichen Eigenschaften aufweisen, wie die in der WO 2010/006681 beschriebenen Komplexe. Betreffend die Berechnung bzw. Messung des Energieabstandes ΔE wird auf die diesbezüglichen Ausführungen in der WO 2010/006681 verwiesen.

Bei der erfindungsgemäßen Vorrichtung handelt es sich insbesondere um eine Vorrichtung aus der Gruppe bestehend aus organischen Elektrolumineszenzvorrichtungen (OLEDs), lichtemittierenden elektrochemischen Zellen (LEECs), organischen Solarzellen (OSCs), organischen Feldeffekttransistoren und organischen Lasern. Weitere in Frage kommende Anwendungsfelder sind OLED-Sensoren, insbesondere nicht hermetisch nach außen abgeschirmte Gas- und Dampf-Sensoren.

Insbesondere wenn es sich bei der erfindungsgemäßen elektronischen Vorrichtung um eine organische Elektrolumineszenzvorrichtung handelt, ist es bevorzugt, dass die Vorrichtung die Metallkomplexverbindung als Bestandteil einer Emitterschicht umfasst. Der Anteil des Metallkomplexes in der Emitterschicht liegt in diesem Fall bevorzugt zwischen 0,1 und 50 Gew.-%.

OLEDs sind bekanntlich aus mehreren Schichten aufgebaut. Meist befindet sich auf einem Substrat wie einer Glasscheibe eine schichtartige Anode, beispielsweise bestehend aus Indium-Zinn-Oxid (ITO). Auf dieser ist eine Lochleitungsschicht (engl. "hole transport layer", HTL) angeordnet. Zwischen der Anode und der Lochleitungsschicht kann sich gegebenenfalls noch eine Schicht aus PEDOT/PSS (Poly(3,4-ethylendioxythiophen)polystyrolsulfonat) befinden, die zur Absenkung der Injektionsbarriere für Löcher dient und die Eindiffusion von Indium in den Übergang verhindert. Auf die Lochleitungsschicht ist in aller Regel die Emitterschicht aufgebracht, die im vorliegenden Fall die oben beschriebene Metallkomplexverbindung mit dem mindestens einen anionischen Liganden enthält. Unter Umständen kann die Emitterschicht auch aus diesem Komplex bestehen. Auf die Emitterschicht wird abschließend eine Elektronenleitungsschicht (engl. "electron transport layer", ETL) aufgebracht. Darauf wird wiederum eine Kathodenschicht, beispielsweise bestehend aus einem Metall oder einer Metalllegierung, im Hochvakuum aufgedampft. Als Schutzschicht und zur Verringerung der Injektionsbarriere für Elektronen kann zwischen Kathode und der ETL gegebenenfalls noch eine dünne Schicht aus Lithiumfluorid, Cäsiumfluorid oder Silber aufgedampft werden.

Die Elektronen (= negative Ladung) wandern im Betrieb von der Kathode in Richtung Anode, welche die Löcher (= positive Ladung) bereitstellt. Löcher und Elektronen treffen sich im Idealfall in der Emitterschicht, weshalb diese auch als Rekombinationsschicht bezeichnet wird. Elektronen und Löcher bilden einen gebundenen Zustand, den man als Exziton bezeichnet. Von einem Exziton kann durch Energieübertrag eine Metallkomplexverbindung wie die vorliegend beschriebene angeregt werden. Diese kann in den Grundzustand übergehen und dabei ein Photon emittieren. Die Farbe des ausgesendeten Lichts hängt dabei vom Energieabstand zwischen angeregtem und Grundzustand ab und kann durch Variation des Komplexes bzw. der Komplexliganden gezielt variiert werden.

Insbesondere wenn es sich bei der erfindungsgemäßen Vorrichtung um eine organische Solarzelle handelt, ist es bevorzugt, dass die Vorrichtung die Metallkomplexverbindung als Bestandteil einer Absorberschicht umfasst, wobei der Anteil der Metallkomplexverbindung in der Absorberschicht bevorzugt zwischen 30 und 100 Gew.-% beträgt. Bei einer organischen Solarzelle handelt es sich um eine Solarzelle, die zumindest überwiegend aus organischen Werkstoffen, d.h. aus KohlenwasserstoffVerbindungen, besteht.

Wie bei OLEDs sind auch bei organischen Solarzellen zwei Elektroden vorgesehen. Zwischen diesen ist die Absorberschicht angeordnet, in welcher der in der vorliegenden Anmeldung beschriebene Metallkomplex zum Einsatz kommt.

Wie bereits erwähnt, können die vorliegend beschriebenen Metallkomplexverbindungen Licht emittieren. Durch Variation der Liganden lässt sich dabei der ΔE-Abstand zwischen dem untersten Triplett-Zustand dem darüberliegenden Singulett-Zustand variieren, so dass es grundsätzlich möglich ist, die Wellenlänge des emittierten Lichtes auf definierte Werte einzustellen, insbesondere auch auf sehr kurzwellige Werte, so dass blaues Licht emittiert wird. Insbesondere mit Kupferkomplexen, die den beschriebenen Komplexliganden aufweisen, wurden diesbezüglich hervorragende Ergebnisse erzielt.

Die beschriebenen Komplexverbindungen sind in der Regel in organischen Lösungsmitteln wie Benzol oder Toluol sehr gut löslich. Das eröffnet die Möglichkeit, ein grundsätzlich beliebiges Substrat mit den Komplexverbindungen zu bedrucken. Entsprechend ist auch ein Verfahren zur Herstellung einer elektronischen Vorrichtung wie den vorstehend beschriebenen Gegenstand der vorliegenden Erfindung, bei dem die beschriebene Metallkomplexverbindung mit dem mindestens einen anionischen Liganden der Formel I auf ein Substrat aufgedruckt wird.

Weitere Merkmale der Erfindung ergeben sich aus der nachfolgenden Beschreibung bevorzugter Ausführungsformen. Es sei an dieser Stelle explizit betont, dass sämtliche in der vorliegenden Anmeldung beschriebenen fakultativen Aspekte der erfindungsgemäßen Vorrichtungen oder der erfindungsgemäßen Verfahren jeweils für sich allein oder in Kombination mit einem oder mehreren der weiteren beschriebenen fakultativen

Aspekte bei einer Ausführungsform der Erfindung verwirktlicht sein können. Die nachfolgende Beschreibung von bevorzugten Ausführungsformen dient lediglich zur Erläuterung und zum besseren Verständnis der Erfindung und ist in keiner Weise einschränkend zu verstehen.

### Ausführungsbeispiele

Es wurden Komplexverbindungen mit folgenden Formeln synthetisiert:
(1) [Cu₂(Ph₂PCPhPPh₂)₂(NC₄H₈)₂]
(2) [Cu(Ph₂PCPhPPh₂)(Ph₂PC₆H₄PPh₂)]
(3) [Cu(Ph₂PCPhPPh₂)(dppbe)]
(4) [Cu(Ph₂PCPhPPh₂)(PN)]
(5) [{Cu(Ph₂PCPhPPh₂)(dmpm)}₂]
(6) [{Cu(Ph₂PCPhPPh₂)(dmpe)}₂]
(7) [Cu₂{PPh₂C(CN)PPh₂}₂phen₂]
(8) [Ag{PPh2C(CN)PPh₂}ₙ]
(9) [Au₂[PPh₂C(CN)PPh₂}₂]
(10) [Cu₂{PPh₂C(Ph)PPh(C₆H₄NMe₂}₂]

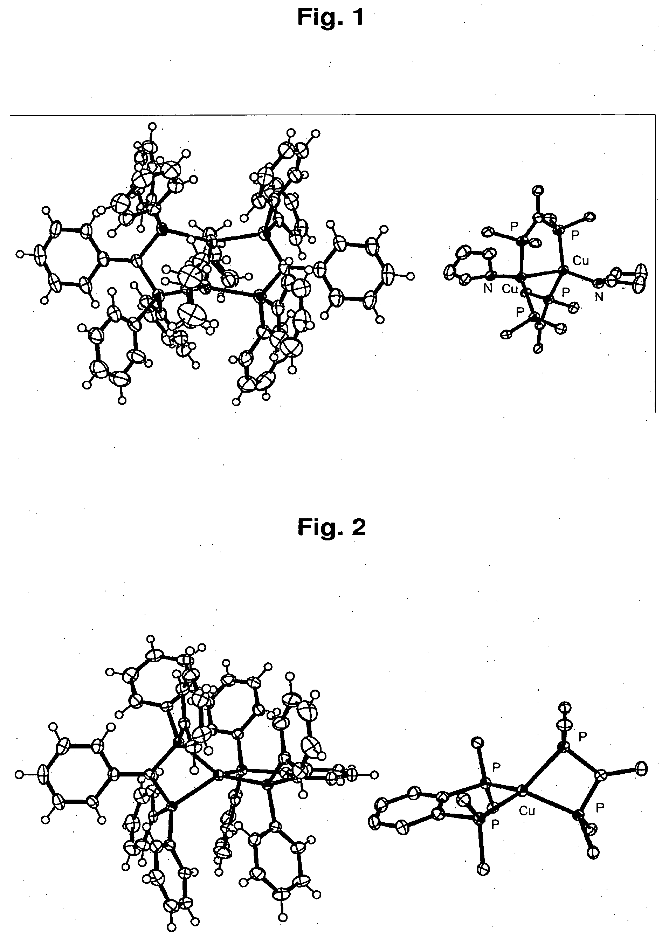

Die anhand von Röntgenstrukturdaten ermittelte Struktur des zweikernigen Kupferkomplexes (1) ist in Fig. 1 dargestellt. Links ist die komplette Molekülstruktur dargestellt, rechts nur das Gerüst des Komplexes ohne Wasserstoffatome und ohne Phenylgruppen.
Die anhand von Röntgenstrukturdaten ermittelte Struktur des einkernigen Kupferkomplexes (2) ist in Fig. 2 dargestellt. Links ist die komplette Molekülstruktur dargestellt, rechts nur das Gerüst des Komplexes ohne Wasserstoffatome und ohne Phenylgruppen.

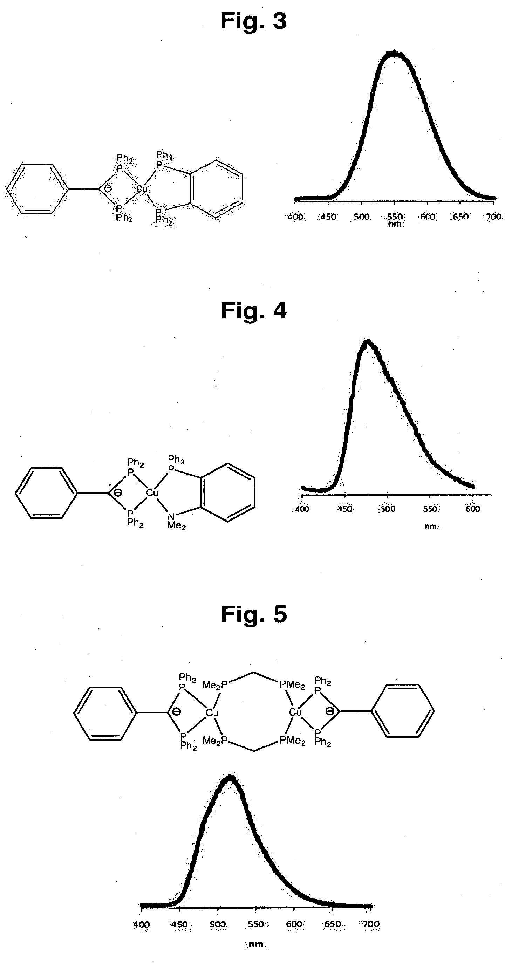

Fig. 3 zeigt links die Strukturformel des einkernigen Kupferkomplexes (3), wobei dppbe für den zweizähnigen Ligand 1,2-Bis(diphenylphosphinobenzol)ethan steht. Rechts ist das Emissionspektrum des Komplexes mit einem Intensitäts-Maximum bei etwa 550 nm dargestellt.
Fig. 4 zeigt links die Strukturformel des einkernigen Kupferkomplexes (4). Rechts ist das Emissionspektrum des Komplexes mit einem Intensitäts-Maximum bei etwa 480 nm dargestellt.
Fig. 5 zeigt oben die Strukturformel des zweikernigen Kupferkomplexes (5), wobei dmpm für den zweizähnigen Ligand Bis(dimethylphosphino)-methan steht. Unten ist das Emissionspektrum des Komplexes mit einem Intensitäts-Maximum bei etwa 520 nm dargestellt.

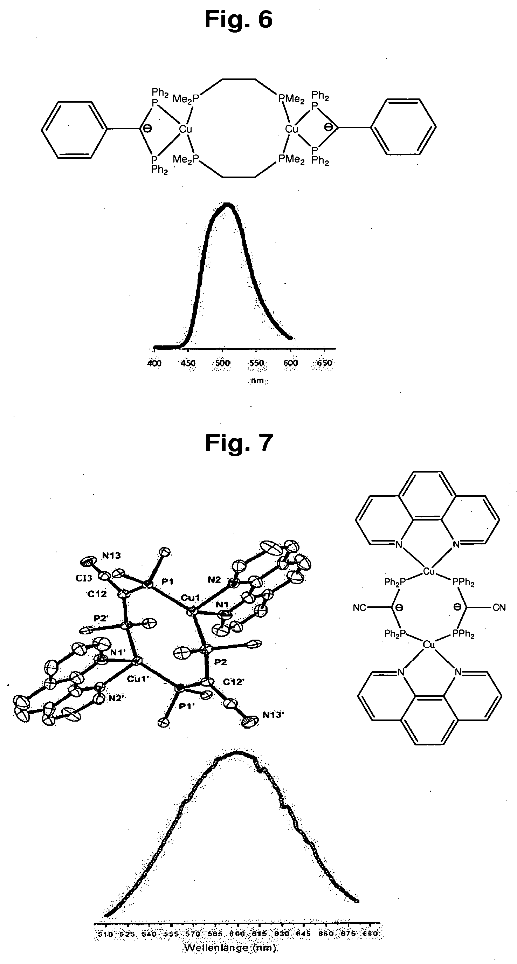

Fig. 6 zeigt oben die Strukturformel des zweikernigen Kupferkomplexes (6), wobei dmpe für den zweizähnigen Ligand Bis(dimethylphosphino)-ethan steht. Unten ist das Emissionspektrum des Komplexes mit einem Intensitäts-Maximum bei etwa 515 nm dargestellt.
Fig. 7 zeigt oben links die anhand von Röntgenstrukturdaten ermittelte Struktur des zweikernigen Kupferkomplexes (7), wobei phen für den zweizähnigen Ligand Phenanthrolin steht. Oben rechts ist die Strukturformel abgebildet. Unten ist das Emissionspektrum des Komplexes mit einem Intensitäts-Maximum bei etwa 515 nm dargestellt.

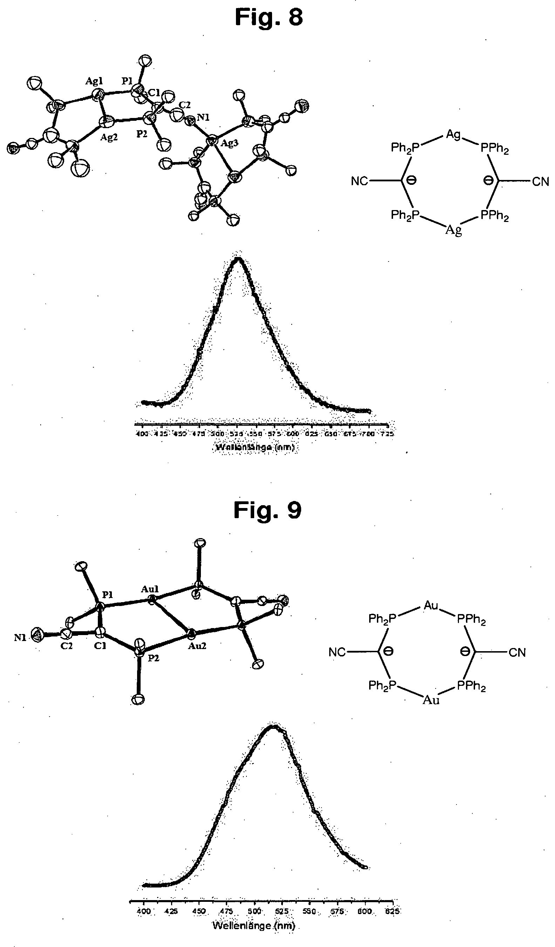

Fig. 8 zeigt oben links die anhand von Röntgenstrukturdaten ermittelte Struktur des zweikernigen Silberkomplexes (8). Oben rechts ist die Strukturformel abgebildet. Unten ist das Emissionspektrum des Komplexes mit einem Intensitäts-Maximum bei etwa 525 nm dargestellt.
Fig. 9 zeigt oben links die anhand von Röntgenstrukturdaten ermittelte Struktur des zweikernigen Goldkomplexes (9). Oben rechts ist die Strukturformel abgebildet. Unten ist das Emissionspektrum des Komplexes mit einem Intensitäts-Maximum bei etwa 520 nm dargestellt.

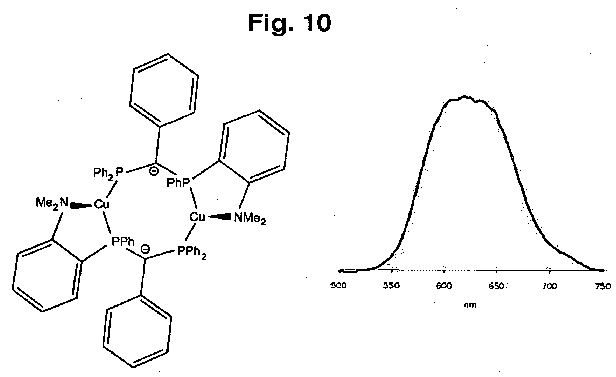

Fig. 10 zeigt links die Strukturformel des zweikernigen Kupferkomplexes (10). Rechts ist das Emissionspektrum des Komplexes mit einem Intensitäts-Maximum bei etwa 620 nm dargestellt.

Alle diese Komplexe zeigten ein hervorragendes Abklingverhalten und waren leicht herstellbar. Nachfolgend wird anhand von zwei Beispielen der allgeimene Syntheseweg beschrieben.

### Synthese des Kupferkomplexes [Cu(Ph₂PCPhPPh₂)(dppbe)] (3):

Kupferamid [Cu(NCH₂)₄] wurde mit einem Äquivalent des Liganden [RCH(PPh₂)] in Toluol unter Rühren vorgelegt. Anschließend erfolgte die Zugabe des zweizähnigen Liganden 1,2-Bis(diphenylphosphinobenzol)-ethan (dppbe). Nach mehrmaliger Rekristallisation aus Toluol konnte der Kupferkomplex (3) in kristalliner Form gewonnen und der Röntgenstrukturanalyse zugeführt werden.

### Synthese des Kupferkomplexes [Cu₂{PPh₂C(Ph)PPh(C₆H₄NMe₂}₂] (10):

Kupferamid [Cu(NCH₂)₄] wurde mit einem Äquivalent des Liganden [Ph₂PPhCHPPh(C₆H₄NMe₂)] in Toluol unter Rühren vorgelegt. Nach Überschichten dieser Reaktionslösung mit n-Hexan konnte der zweizähnige Kupferkomplex (10) in kristalliner Form gewonnen und der Röntgenstrukturanalyse zugeführt werden.

## Patentansprüche

1. Elektronische Vorrichtung, enthaltend eine Metallkomplexverbindung mit mindestens einem anionischen Liganden mit zwei P-Donoren mit der Formel I 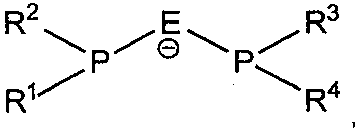 in der
• R¹ bis R⁴ unabhängig voneinander ein Atom oder Rest aus der Gruppe umfassend Wasserstoff, ein Halogen, R-, RO-, RS-, RCO-, RCOO-, RNH-, R₂N-, RCONR- und -Si(R)_{X}(OR)_{3-X} mit R = ein C₁-C₄₀-Kohlenwasserstoff und X = 1, 2 oder 3 sind und
• E ein Kohlenstoff oder ein Bor ist, wobei
- an den Kohlenstoff gegebenenfalls ein Atom oder Rest aus der Gruppe mit Wasserstoff, Halogen, -CN, R-, RO-, RS-, RCO-, RCOO-, RNH-, R₂N-, RCONR- und -Si(R)_{X}(OR)_{3-X} mit R = dem C₁-C₄₀-Kohlenwasserstoff und X = 1, 2 oder 3 gebunden ist, und
- an das Bor gegebenenfalls zwei Reste aus der Gruppe mit Halogen, R-, RO-, RS-, RCO-, RCOO-, RNH-, R₂N-, RCONR- und -Si(R)_{X}(OR)_{3-X} mit R = dem C₁-C₄₀-Kohlenwasserstoff und X = 1, 2 oder 3 gebunden sind.

2. Vorrichtung nach Anspruch 1, **dadurch gekennzeichnet, dass** der C₁- bis C₄₀-Kohlenwasserstoff R ein Alkyl-, Cycloalkyl-, Alkenyl-, Cycloalkenyl-, Alkinyl-, Cycloalkinyl-, Alkylcycloalkyl-, Heteroalkyl-, Heterocycloalkyl-, Heteroalkylcycloalkyl-, Aryl-, Heteroaryl-, Aralkyl- oder Heteroaralkyl-Rest ist, von denen jeder in bevorzugten Ausführungsformen eine oder mehrere Halogen-, Hydroxy-, Thiol-, Carbonyl-, Keto-, Carboxyl-, Cyano-, Sulfon-, Nitro-, Amino- und/ oder Iminofunktionen aufweisen kann.

3. Vorrichtung nach einem der Ansprüche 1 oder 2, **dadurch gekennzeichnet, dass** mindestens eines der beiden P ein Ringatom eines Ringsystems aromatischer oder nichtaromatischer Natur ist (welches die Reste R¹ und R² und/oder R³ und R⁴ umfasst).

4. Vorrichtung nach einem der Ansprüche 1 bis 3, **dadurch gekennzeichnet, dass** die Metallkomplexverbindung einkernig oder mehrkernig ist, bevorzugt ein bis sechs Metallzentren aufweist.

5. Vorrichtung nach einem der vorhergehenden Ansprüche, **dadurch gekennzeichnet, dass** die Metallkomplexverbindung zumindest eines der Metalle Cu, Ag, Au, Pd, Pt, Rh, Ir, Re, Os, Mo, W und Zn in bevorzugt ionischer Form umfasst.

6. Vorrichtung nach Anspruch 5, **dadurch gekennzeichnet, dass** die Metallkomplexverbindung ein Cu- oder ein Ag-Ion sowie mindestens ein weiteres Metall aus der Gruppe mit Cu, Ag, Au, Pd, Pt, Rh, Ir, Re, Os, Mo, W oder Zn umfasst.

7. Vorrichtung nach einem der vorhergehenden Ansprüche, **dadurch gekennzeichnet, dass** die Metallkomplexverbindung die Formel II 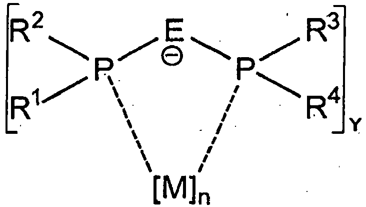 aufweist, in der
• R¹ bis R⁴ und E definiert sind wie in Formel I,
• [M]ₙ ein Komplexfragment darstellt mit M = mindestens ein Metall aus der Gruppe mit Cu, Ag, Au, Pd, Pt, Rh, Ir, Re, Os, Mo, W und Zn,
• n gleich 1 oder eine höhere ganze Zahl ist und
• y gleich 1, 2 oder 3 ist.

8. Vorrichtung nach einem der vorhergehenden Ansprüche, **dadurch gekennzeichnet, dass** die Metallkomplexverbindung einen ΔE-Abstand zwischen dem untersten Triplett-Zustand und dem darüber liegenden Singulett-Zustand zwischen 50 cm⁻¹ und 3000 cm⁻¹ aufweist.

9. Vorrichtung nach einem der vorhergehenden Ansprüche, ausgewählt aus der Gruppe bestehend aus organischen Elektrolumineszenzvorrichtungen (OLEDs), lichtemittierenden elektrochemischen Zellen (LEECs), organischen Solarzellen (OSCs), organischen Feldeffekttransistoren und organischen Lasern.

10. Vorrichtung nach einem der vorhergehenden Ansprüche, **dadurch gekennzeichnet, dass** sie die Metallkomplexverbindung als Bestandteil einer Emitterschicht umfasst, wobei der Anteil des Metallkomplexes in der Emitterschicht bevorzugt zwischen 0.1 und 50 Gew.-% beträgt.

11. Vorrichtung nach einem der vorhergehenden Ansprüche, **dadurch gekennzeichnet, dass** sie die Metallkomplexverbindung als Bestandteil einer Absorberschicht umfasst, wobei der Anteil des Metallkomplexes in der Absorberschicht bevorzugt zwischen 30 und 100 Gew.-% beträgt.

12. Verfahren zur Erzeugung von blauer Emission unter Verwendung einer Metallkomplexverbindung mit einem Liganden mit zwei P-Donoren mit der Formel I.

13. Verfahren zur Herstellung einer elektronischen Vorrichtung nach einem der vorhergehenden Ansprüche, **dadurch gekennzeichnet, dass** die Metallkomplexverbindung mit dem mindestens einen anionischen Liganden der Formel I auf ein Substrat aufgedruckt wird.

## Claims

1. Electronic device comprising a metal complex compound having at least one anionic ligand containing two P donors, having the formula I 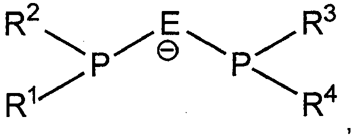 in which
• R¹ to R⁴ are, independently of one another, an atom or radical from the group comprising hydrogen, a halogen, R-, RO-, RS-, RCO-, RCOO-, RNH-, R₂N-, RCONR- and -Si(R)_{X}(OR)_{3-X}, where R = a C₁-C₄₀-hydrocarbon and X = 1, 2 or 3, and
• E is a carbon or a boron, where
- an atom or radical from the group with hydrogen, halogen, -CN, R-, RO-, RS-, RCO-, RCOO-, RNH-, R₂N-, RCONR- and -Si(R)_{X}(OR)_{3-X}, where R = the C₁-C₄₀-hydrocarbon and X = 1, 2 or 3, is optionally bonded to the carbon, and
- two radicals from the group with halogen, R-, RO-, RS-, RCO-, RCOO-, RNH-, R₂N-, RCONR- and -Si(R)_{X}(OR)_{3-X}, where R = the C₁-C₄₀-hydrocarbon and X = 1, 2 or 3, are optionally bonded to the boron.

2. Device according to Claim 1, **characterised in that** the C₁- to C₄₀-hydrocarbon R is an alkyl, cycloalkyl, alkenyl, cycloalkenyl, alkynyl, cycloalkynyl, alkylcycloalkyl, heteroalkyl, heterocycloalkyl, heteroalkylcycloalkyl, aryl, heteroaryl, aralkyl or heteroaralkyl radical, each of which may, in preferred embodiments, have one or more halogen, hydroxyl, thiol, carbonyl, keto, carboxyl, cyano, sulfone, nitro, amino and/or imino functions.

3. Device according to one of Claims 1 or 2, **characterised in that** at least one of the two P is a ring atom of a ring system of an aromatic or non-aromatic nature (which includes the radicals R¹ and R² and/or R³ and R⁴).

4. Device according to one of Claims 1 to 3, **characterised in that** the metal complex compound is mononuclear or polynuclear, preferably has one to six metal centres.

5. Device according to one of the preceding claims, **characterised in that** the metal complex compound includes at least one of the metals Cu, Ag, Au, Pd, Pt, Rh, Ir, Re, Os, Mo, W and Zn in preferably ionic form.

6. Device according to Claim 5, **characterised in that** the metal complex compound includes a Cu or Ag ion and at least one further metal from the group with Cu, Ag, Au, Pd, Pt, Rh, Ir, Re, Os, Mo, W or Zn.

7. Device according to one of the preceding claims, **characterised in that** the metal complex compound has the formula II 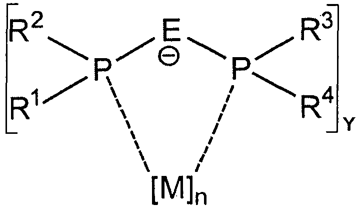 in which
• R¹ to R⁴ and E are defined as in formula I,
• [M]ₙ represents a complex fragment where M = at least one metal from the group with Cu, Ag, Au, Pd, Pt, Rh, Ir, Re, Os, Mo, W and Zn,
• n is equal to 1 or a higher integer and
• y is equal to 1, 2 or 3.

8. Device according to one of the preceding claims, **characterised in that** the metal complex compound has a ΔE separation between the lowest triplet state and the higher singlet state of between 50 cm⁻¹ and 3000 cm⁻¹.

9. Device according to one of the preceding claims, selected from the group consisting of organic electroluminescent devices (OLEDs), light-emitting electrochemical cells (LEECs), organic solar cells (OSCs), organic field-effect transistors and organic lasers.

10. Device according to one of the preceding claims, **characterised in that** it comprises the metal complex compound as constituent of an emitter layer, where the proportion of the metal complex in the emitter layer is preferably between 0.1 and 50% by weight.

11. Device according to one of the preceding claims, **characterised in that** it comprises the metal complex compound as constituent of an absorber layer, where the proportion of the metal complex in the absorber layer is preferably between 30 and 100% by weight.

12. Process for the generation of blue emission using a metal complex compound having a ligand containing two P donors, having the formula I.

13. Process for the production of an electronic device according to one of the preceding claims, **characterised in that** the metal complex compound having the at least one anionic ligand of the formula I is printed onto a substrate.

## Revendications

1. Dispositif électronique comprenant un composé de complexe métallique comportant au moins un ligand anionique contenant deux donneurs P, présentant la formule I : 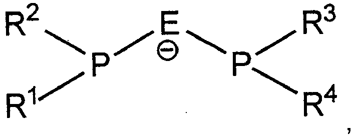 dans laquelle :
• R¹ à R⁴ sont, indépendamment les uns des autres, un atome ou un radical pris parmi le groupe comprenant hydrogène, un halogène, R-, RO-, RS-, RCO-, RCOO-, RNH-, R₂N-, RCONR- et -Si(R)_{X}(OR)_{3-X}, où R = un C₁-C₄₀-hydrocarbone et X = 1, 2 ou 3, et
• E est un carbone ou un bore, où
- un atome ou un radical pris parmi le groupe comprenant hydrogène, halogène, -CN, R-, RO-, RS-, RCO-, RCOO-, RNH-, R₂N-, RCONR- et -Si(R)_{X}(OR)_{3-X}, où R = le C₁-C₄₀-hydrocarbone et X = 1, 2 ou 3, est en option lié au carbone, et
- deux radicaux pris parmi le groupe comprenant halogène, R-, RO-, RS-, RCO-, RCOO-, RNH-, R₂N-, RCONR- et - Si(R)_{X}(OR)_{3-X}, où R = le C₁-C₄₀-hydrocarbone et X = 1, 2 ou 3, sont en option liés au bore.

2. Dispositif selon la revendication 1, **caractérisé en ce que** le C₁- à C₄₀-hydrocarbone R est un radical alkyle, cycloalkyle, alkényle, cycloalkényle, alkynyle, cycloalkynyle, alkylcycloalkyle, hétéroalkyle, hétérocycloalkyle, hétéroalkylcycloalkyle, aryle, hétéroaryle, aralkyle ou hétéroaralkyle, dont chacun peut, selon des modes de réalisation préférés, comporter une ou plusieurs fonctions halogène, hydroxyle, thiol, carbonyle, céto, carboxyle, cyano, sulfone, nitro, amino et/ou imino.

3. Dispositif selon l'une des revendications 1 ou 2, **caractérisé en ce qu'**au moins l'un des deux P est un atome de cycle d'un système de cycle d'une nature aromatique ou non aromatique (lequel inclut les radicaux R¹ et R² et/ou R³ et R⁴).

4. Dispositif selon l'une des revendications 1 à 3, **caractérisé en ce que** le composé de complexe métallique est mononucléaire ou polynucléaire, de façon préférable il comporte un à six centres métalliques.

5. Dispositif selon l'une des revendications précédentes, **caractérisé en ce que** le composé de complexe métallique inclut au moins l'un des métaux Cu, Ag, Au, Pd, Pt, Rh, Ir, Re, Os, Mo, W et Zn de façon préférable sous forme ionique.

6. Dispositif selon la revendication 5, **caractérisé en ce que** le composé de complexe métallique inclut un ion Cu ou Ag et au moins un autre métal pris parmi le groupe comprenant Cu, Ag, Au, Pd, Pt, Rh, Ir, Re, Os, Mo, W ou Zn.

7. Dispositif selon l'une des revendications précédentes, **caractérisé en ce que** le composé de complexe métallique présente la formule II : 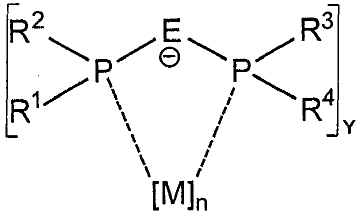 dans laquelle :
• R¹ à R⁴ et E sont définis comme selon la formule I,
• [M]ₙ représente un fragment de complexe où M = au moins un métal pris parmi le groupe comprenant Cu, Ag, Au, Pd, Pt, Rh, Ir, Re, Os, Mo, W et Zn,
• n est égal à 1 ou à un entier plus grand et
• y est égal à 1, 2 ou 3.

8. Dispositif selon l'une des revendications précédentes, **caractérisé en ce que** le composé de complexe métallique présente une séparation ΔE entre l'état de triplet le plus bas et l'état de singlet plus haut comprise entre 50 cm⁻¹ et 3000 cm⁻¹.

9. Dispositif selon l'une des revendications précédentes, choisi parmi le groupe constitué par des dispositifs électroluminescents organiques (OLED), des cellules électrochimiques d'émission de lumière (LEEC), des cellules solaires organiques (OSC), des transistors à effet de champ organiques et des lasers organiques.

10. Dispositif selon l'une des revendications précédentes, **caractérisé en ce qu'**il comprend le composé de complexe métallique en tant que constituant d'une couche d'émetteur, où la proportion du complexe métallique dans la couche d'émetteur est de façon préférable entre 0,1 et 50% en poids.

11. Dispositif selon l'une des revendications précédentes, **caractérisé en ce qu'**il comprend le composé de complexe métallique en tant que constituant d'une couche d'absorbeur, où la proportion du complexe métallique dans la couche d'absorbeur est de façon préférable entre 30 et 100% en poids.

12. Procédé pour la génération d'une émission de bleu en utilisant un composé de complexe métallique comportant un ligand contenant deux P donneurs, présentant la formule I.

13. Procédé pour la fabrication d'un dispositif électronique selon l'une des revendications précédentes, **caractérisé en ce que** le composé de complexe métallique comportant l'au moins un ligand anionique de la formule I est imprimé sur un substrat.
